# EUROPEAN PATENT SPECIFICATION

(11) **EP 0 387 924 B1**
(45) Date of publication and mention of the grant of the patent: **27.09.1995**
(21) Application number: 90109867.3
(22) Date of filing: 19.12.1984
(51) Int. Cl.: H03M 13/00

(54) **Method and apparatus for decoding error correction code**
Verfahren und Vorrichtung zur Dekodierung eines fehlerkorrigierenden Kodes
Méthode et appareil de décodage d'un code de correction d'erreur

(30) Priority: 20.12.1983 JP 240525/83; 23.12.1983 JP 198079/83 U
(43) Date of publication of application: 19.09.1990
(62) Divisional of application: 85900195.0
(73) Proprietor: SONY CORPORATION, Tokyo (JP)
(72) Inventor: Ozaki, Shinya, c/o Sony Corporation, Tokyo 141 (JP); Odaka, Kentaro, c/o Sony Corporation, Tokyo 141 (JP); Fukami, Tadashi, c/o Sony Corporation, Tokyo 141 (JP)
(74) Representative: Senior, Alan Murray

(56) References cited:
- US-A- 3 714 629
- US-A- 4 142 174
- RADIO AND ELECTRONIC ENGINEER, vol. 52, no. 4, April 1982, London,GB,pages 188- 192; FARRELL et al.:"Burst-error correcting array codes"

## Description

### TECHNICAL FIELD

This invention relates to a method and an apparatus for decoding error correction code.

### BACKGROUND ART

Product code are well known such that information symbols are arranged in two-dimensional form, error correction codes are encoded for each row and column of the two-dimensional arrangement so that each information symbol is included in two error correction code series. In decoding the product code, the error correction code is decoded for each column and error correction code can be decoded for each row by employing the decode information. The decode information is called a pointer.

In the conventional methods, since each information symbol is associated with a pointer, it is required that the total number of pointers is at least equal to the number of information symbols.

Further, in the case where erasure correction is made by employing the pointers, since the pointers are read out from a pointer memory and the error value is calculated for every row, there exists a problem in that the number of processing steps such as memory accesses, calculations and so on inevitably increases.

On the other hand, in the case where complicated codes such as BCH codes are employed as error correction codes, since the operations for obtaining error values become inevitably complicated, there exists a problem in that a great number of program steps are required in the case where the calculations are implemented by hardware.

IBM Technical Disclosure Bulletin, Vol. 17, No. 2, July 1974, pages 473-475 discloses an error correction system for taped data in which error pointers from column decoding are used in error correction of rows of the data.

EP-A2-0096109 (Tokyo Shibaura Denki K.K.) is part of the state of the art by virtue of Article 54(3) E.P.C. and discloses a decoding method using a single Reed-Solomon-Code.

An object of this invention is to provide a method and an apparatus for decoding error correction codes which can reduce the number of pointers required in decoding as well as reducing the number of memory regions for the pointers and the number of times the pointers need to be read and written to.

Another object of this invention is to provide a method and an apparatus for decoding error correction code which can markedly reduce the number of processing steps in dependence upon the fact that the pointers with respect to each row are the same.

Still another object of this invention is to provide an apparatus for decoding error correction codes which can reduce the number of calculating steps in an erasure correction.

Afurther object of this invention is to provide a method for decoding error correction codes which can obtain error values in decoding having a simple construction and a small number of processing steps.

According to the present invention there is provided a method for decoding and correcting Reed-Solomon code comprising the steps of:
solving the expression 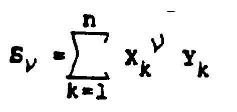 where,
v=Otod-2
n : Number of erasure
Xₖ : Location of kth element
Sᵥ : Syndrome
Yk: Magnitude of error in the erasure of kth element
d : Minimum distance of code
   to obtain roots of the expression;

making erasure correction of errors encoded in the Reed-Solomon code in accordance with the roots, characterized in that;

the roots are obtained by solving the expression 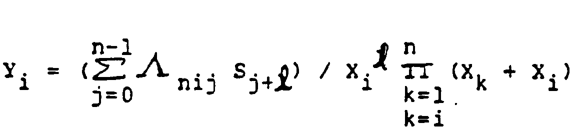 where Λₙᵢⱼ : Coefficient of Zi of 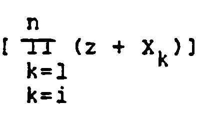 f : Any integer more than or equal to 0 which satisfies f < d - n - 1

This invention also provides an apparatus for decoding and correcting erasure in Reed-Solomon code in accordance with the roots of 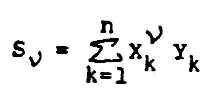 where,
ν = 0 to d - 2
n : Number of erasure
Xₖ : Location of kth element
Sᵥ : Syndrome
Yk: Magnitude of error in the erasure of kth element
d : Minimum distance of the code
   comprising

syndrome register means for storing syndrome Sᵥ; and characterized by operating logic means for obtaining the roots Yᵢ by solving the expression: 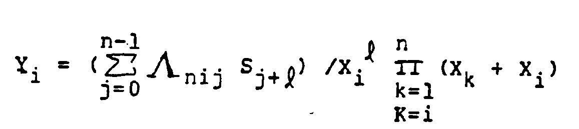 where Λₙᵢⱼ : Coefficient of Zi of 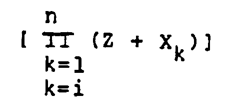
f : Any integer more than or equal to 0 which satisfies l ≦ d - n - 1
   whereby said operating logic means includes
register means for storing syndrome Sᵥ;
register means for storing X^{v}ᵢ Yᵢ;
register means for storing Xᵢ;

adder means for adding Sᵥ and X^{v}ᵢYᵢ and for supplying said register means and syndrome register means with Sᵥ + X^{v}ᵢ Yᵢ;

multiplyer means for multiplying Xᵢ and X^{v}ᵢYᵢ and for supplying said register means with X^{v}ᵢYᵢ.

The invention will be further described by way of non-limitative example with reference to the accompanying drawings in which:-
Fig. 1 is a schematic block diagram of an encoder according to an embodiment of the present invention.
Fig. 2 is a schematic block diagram showing the operation of an embodiment of the present invention.
Fig. 3 is a schematic block diagram showing a decoder according to one embodiment of this invention.
Fig. 4 is a block diagram showing an error correcting decoder according to Figure 3.
Fig. 5 is a block diagram of a part of the error location and error value calculating circuit of Figure 4.
Fig. 6 is a block diagram showing a construction of a second embodiment for use with this invention.
Fig. 7 is a block diagram for the processing circuit of Fig. 6.

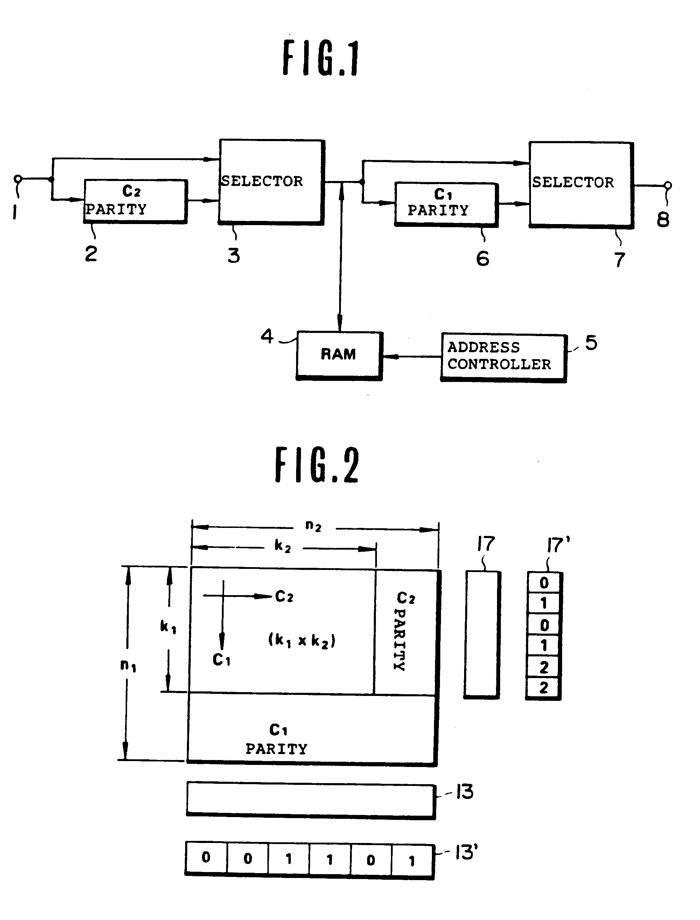

An embodiment of the present invention will be described, referring to the drawings. Fig. 1 shows a structure of an encoderfor product code. The reference numeral 1 denotes an input terminal, the reference numeral 2 denotes a second error correction code C₂ parity generator. The input data from the input terminal 1 is supplied to the C₂ parity generator 2 and one input terminal of a selector 3. The C₂ parity data formed by the C₂ parity generator 2 is supplied to the other input terminal of the selector 3. The selector 3 repeats k₁ times the operations for selecting (n₂ - k₂) parity data after k₂ information symbols are selected. During this operation, the information symbols and the parity data are stored in a RAM (Random Access Memory) 4 in sequence under control of an address controller 5.

The data read out from the RAM 4 is supplied to a C₁ (the first error correction code) parity generator 6 and one input terminal of a selector 7 and the C₁ parity data formed by the C₁ parity generator 6 is supplied to the other input terminal of the selector 7. The selector 7 selects ((n₁ - k₁) x k₂) C₁ parity data after having selected (k₁ x n₂) symbols including the C₂ parity data. The digital data derived from an output terminal 8 of the selector 7 are transmitted or recorded on a magnetic tape (not shown) with a magnetic head, for instance. In this case, it is possible to write again the encoded output once into the RAM 4 and to read out it in different sequence for recording.

Fig. 2 shows a configuration of code formed by the encoder as described above. The information symbols are arranged in two dimensions of (k₁ x k₂). The k₂ information symbols in every lateral direction, that is, in every row of the two-dimensional arrangement are subjected to the encoding process for the C₂ code. The k₁ information symbols in every vertical direction, that is, in every column are subjected to the encoding process for the C₁ code. The C₂ parity data is also encoded into the C₁ code. The C₁ code is, for instance, (n₁, k₁) Reed-Solomon code, by which it is possible to correct errors of up to (n₁ - k₁)/2 symbols.

The general method of decoding the Reed-Solomon code will be described.

The hamming distance of the (n, k) Reed-Solomon code where denotes the code length and k denotes the number of information symbols) on a Galois Field GF(2ₘ) can be expressed as (d = n - k + 1) and the generator polynomial can be expressed as 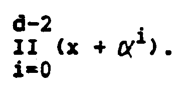 If the received words are (rₒ, r₁, r₂, ..... , rₙ₋₁), the syndrome can be obtained by operating the following expression:

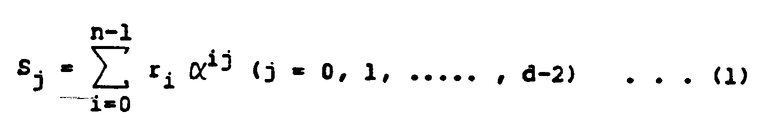

An error location polynomial σ(z) and an error evaluation polynomial ω(z) are obtained by employing the syndrome Sⱼ. As to this method, Euclid's mutual division method, Varlay-Camp's method, Peterson's method and so on have been proposed.

By solving σ(z) = 0, the error location Xᵢ can be obtained. For this purpose, a Chien search is employed.

Then, the error value Yᵢ can be obtained on the basis of the error location Xᵢ and the error evaluation polynomial ω(z).

The above calculations in the decoding steps are explained with the error location as Xᵢ (i = 1, 2, ..... , e : e denotes the number of errors), and the error value as Yᵢ. Since the Reed-Solomon code is a linear code, the syndrome can be expressed as: 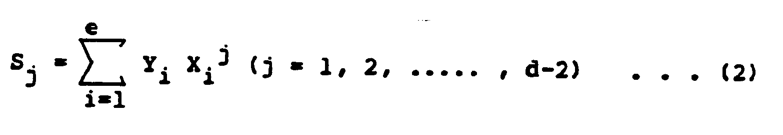 if the syndrome is expressed by a polynomial as: 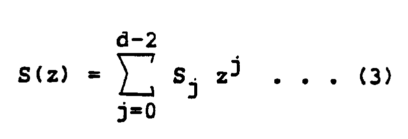 a following expression is obtained: 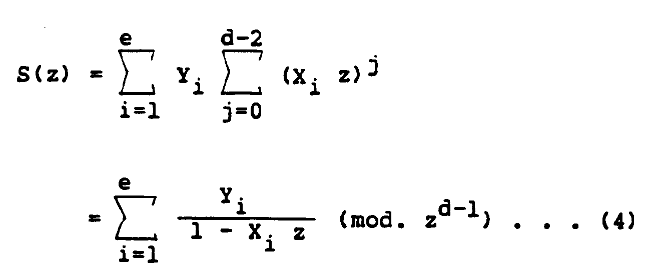 If the error location polynomial and the error evaluation polynomial are defined as 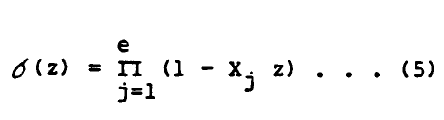 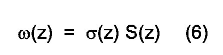 then ω(z) can be expressed as 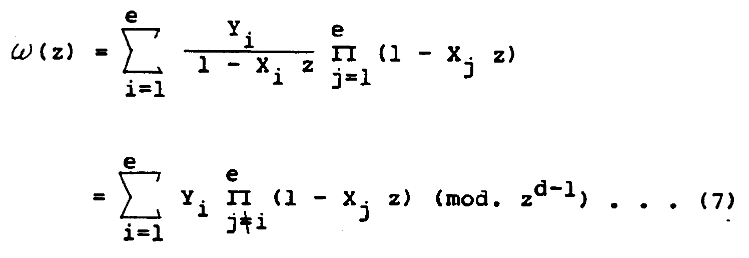 The error value Yᵢ can be obtained by substituting Xᵢ⁻¹ into z and by transforming the expression as follows:

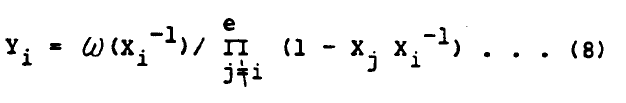

As an example, a (32, 24) Reed-solomon code having roots of α⁰ to a⁷ will be explained. Since this code is (d=8), it is possible to correct errors of up to 4 symbols. If the error locations of the 4 symbols are X₁ to X₄ and the error values are Y₁ to Y₄, the syndrome is obtained from following expression. 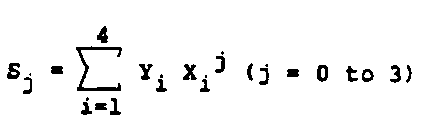 Namely, So is as follows among 4 syndromes: 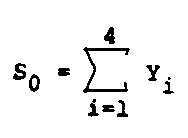 Once the error values Y₁, Y₂, Y₃ can be obtained, the remaining error value Y₄ is obtained as follows without implementing complicated calculations: 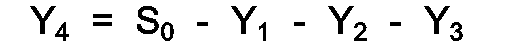 In codes on GF(2m), a subtraction is equivalent to an addition of (mod. 2).

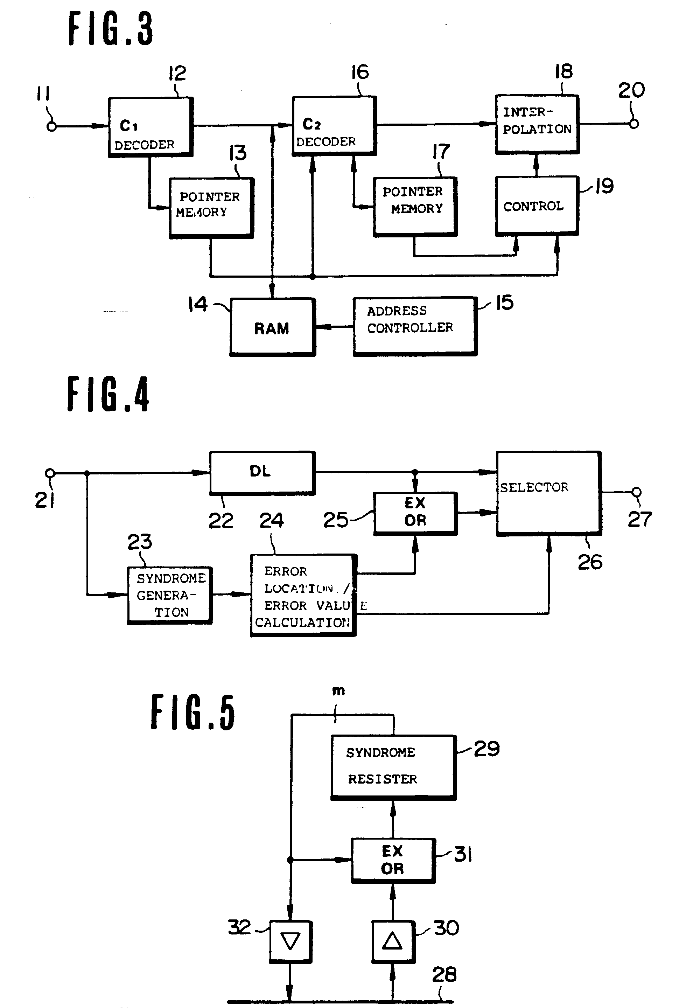

Fig. 3 shows a configuration of the decoder of this embodiment. In Fig. 3, the reproduced data is supplied from an input terminal designated by the reference numeral 11 and to a C₁ decoder 12. In the C₁ decoder 12, the decoding of the C₁ code is performed. All errors of up to (n₁ - k₁)/2 symbols are corrected in the C₁ decoding. In the case, however, where the number of errors in a single series of C₁ code is more than or equal to (n₁ - k₁)/27, the C₁ pointer of this series is set to "1", the other pointers are set to "0". In Figs. 2 and 3, the reference numeral 13 denotes a pointer memory for storing the pointers of the C₁ code, which has n₂ bits. The output of the C₁ decoder 12 is stored temporarily in a RAM 14 in sequence under the control of an address controller 15.

The output read out from the RAM 14 is supplied to a C₂ decoder 16 to be subjected to the decoding of the C₂ code. The C₂ decoder 16 is supplied with the C₁ pointerfrom the pointer memory 13. Since the C₁ pointer is common to the all of K₁ series of C₂ code, it is possible to decode the C₂ code in accordance with the same procedure in each series. The C₂ decoder 16 corrects errors of up to (n₂ - k₂)/2 symbols and generates one of three kinds of pointers in the C₂ code which are stored in a pointer memory 17.

When error correction is perfomed by the C₂ decoder 16, the C₂ pointer with respect to the series is set to "0". When error correction can not be performed by the C₂ decoder 16 and the C₁ pointers are copied because of its high reliability, the C₂ pointer is set to "1". When error correction can not be performed by the C₂ decoder 16 and all symbols are determined to be erroneous symbols because of low reliability of the C₁ pointer, the C₂ pointers are set to "2". Therefore, the C₂ pointers have 2 bits and the pointer memory 17 has 2K₁ bits.

The pointer memories 13 and 17 are disposed separately from the RAM 14 for storing information symbols and parity data in decoding or may be disposed in common with the RAM 14 by using a part of the memory regions of RAM 14.

Without being limited to 1 bit, the C₁ pointer may have 2 bits or more. Further, it is possible to implement the error correction code processing of the C₂ code for the C₁ parity, while providing a C₂ pointer memory of (2n₁) bits.

The output data of the C₂ decoder 16 is supplied to an interpolation circuit 18 to conceal errors in the symbols which have not been corrected. The interpolation circuit 18 performs the mean value interpolation, for instance. The interpolation circuit 18 is controlled by a control circuit 19 which is supplied with the C₁ pointers and the C₂ pointers from the pointer memories 13 and 17. The output data of the interpolation circuit 18 is derived at an output terminal 20. The control circuit 19 determines by every information symbol whether interpolation is necessary on the basis of the c₁ pointer and c₂ pointer. In Fig. 2, There exist all the combinations of C₁ pointers designated as 13' and C₂ pointers designated as 17'.

When the C₂ pointer is "0" irrespective of the fact that the C₁ pointer is "0" or "1", the interpolation circuit 18 does not work. When the C₂ pointer is "1" and the C₁ pointer is "0", since it is determined that the information symbol has no error, no interpolation is done. When the C₂ pointer is "1" and the C₁ pointer is "1", since it is determined that it is an erroneous symbol, the interpolation operation is performed. Further when the C₂ pointer is "2" irrespective of the fact that the C₁ pointer is "0" to "1", since it is determined that it is an erroneous symbol, the interpolation operation is performed.

The reliability of the C₁ pointers is evaluated by the C₂ decoder. For instance, provided that up to 2 symbol errors can be corrected by the C₂ code, if correction by the C₂ code can not be performed in spite of the fact that only one C₁ pointer is "1 ", it is determined that the reliability of the C₁ pointer is low because the above is abnormal. Even if errors are not corrected by the C₂ code, it is possible to eliminate the necessity of interpolation by providing three kinds 0, 1, 2 of the C₂ pointers and by discriminating the copies of C₁ pointers from all errors.

In the above mentioned C₂ decoder 16, when the C₁ pointers are copied, the erasure correction is made where the total value of the C₁ pointers is less than or equal to (n₂ - k₂) and when the erasure correction is made, the C₂ pointer is set to "0".

As described above, the decoding of the Reed-Solomon code is performed by calculation of the error location polynomial σ(z) and the error evaluation polynomial m(z) in every row and by employing the syndrome obtained by n₂ symbols in each row. In the case of erasure correction, since the locations where the C₁ pointers are "1" are determined as the error locations, it is possible to obtain the error value Yᵢ from the error location Xᵢ and the error evaluation polynomial ω(z). That is to say, by substituting Xᵢ-1 in place of z, Yᵢ can be obtained as follows, as in expression (8): 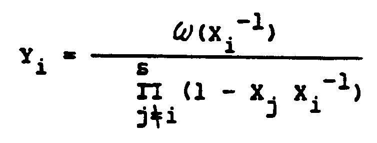 (where i = 1, 2, 3, ...s ; s denotes the number of symbols) In the above expression, the term of denominator can be determined only by the error locations. For instance, provided that the error locations show by the C₁ pointer are X₁, X₂, X₃, the terms of denominator of the expressions for obtaining the error values Y₁, Y₂, Y₃ are
Denominator of Y₁ : (1 - X₂ X₁-1) (1 - X₃ X₁-¹)
Denominator ofY2: (1 - X₁ X₃-1) (1 - X₂ X₃⁻¹)
Denominator of Y₃ : (1 - X₁ X₂-1) (1 - X₃ X₂-1)

Here, the pointers stored in the pointer memory 13 are the same in all the K₁ series of the C₂ code. Therfore, it is sufficient to implement the calculation of the term of the denominator in the above expression to obtain an error value only once with respect to the kᵢ series.

Fig. 4 shows the configuration of an error correcting decoder for use with the above mentioned C₁ and C₂ decoders. The received data is supplied to an input terminal designated by the reference numeral 21 and supplied to a delay circuit 22 and a syndrome generating circuit 23. The syndromes formed by the syndrome generating circuit 23 are supplied to an error location and error value calculating circuit 24. The error data from the error location and error value calculating circuit 24 are supplied to an exclusive OR gate 25 and added to the received data from the delay circuit 22 in (mod. 2). The received data from the delay circuit 22 and the error corrected data from the exclusive OR gate 25 are supplied to a selector 26. The selector 26 is controlled by the error location data. At the error locations, the output of the exclusive OR gate 25 is selected by the selector 26 to be derived at an output terminal 27 in place of the received data.

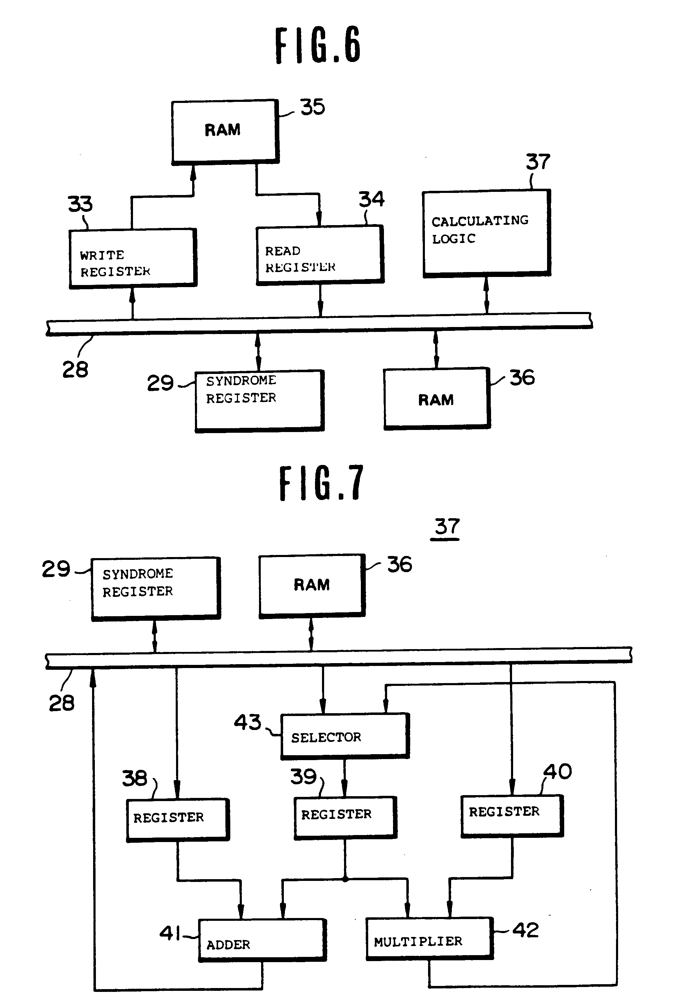

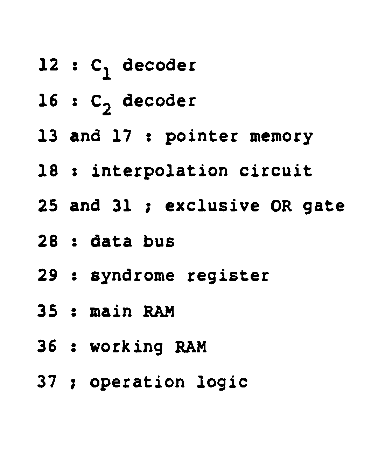

In the case of an audio PCM signal recording and reproducing apparatus, the reproduced data is once written in a RAM. By use of the data read out from the RAM, the syndrome is generated and on the basis of which the error locations and the error values are calculated. Fig. 5 shows a part of the error location and error value calculating circuit 24. In Fig. 5, the reference numeral 28 denotes a data bus through which data and syndrome and so on are transferred.

In Fig. 5, the reference numeral 29 denotes a syndrome register in which the syndrome So is stored through the data bus 28, a bus buffer 30 and an exclusive OR gate 31. the syndrome So has m bits in the case of Reed-Solomon code on GF(2ₘ). The syndrome So from the syndrome register 29 is supplied to the exclusive OR gate 31 and the bus buffer 32.

When the syndrome So is stored in the syndrome register 29, the obtained error values Y₁, Y₂, Y₃ are supplied to the exclusive OR gate 31 in sequence from the data bus 28 through the bus buffer 30. Therefore, the output of the exclusive OR gate 31 is (So ⊕ Yᵢ), (So ⊕ Y₁ ⊕ Y₂) and (So ⊕ Y₁ ⊕ Y₂ ⊕ Y₃ = Y₄). The error value Y₄ is left in the syndrome register 29. The error value Y₄ is outputted to the data bus 28 through the bus buffer 32 to be employed for error correction.

Fig. 6 shows another example of hardware for decoding in an erasure correction. A main RAM 35 is connected to the data bus 28 through a writing register 33 and a reading register 34. The syndrome register 29, a working RAM 36 and an operation logic circuit 37 are also provided to the data bus 28.

The erasure correction by Reed-Solomon code can be obtained by solving the following n-order linear simultaneous equations in the same way as in expression (2): 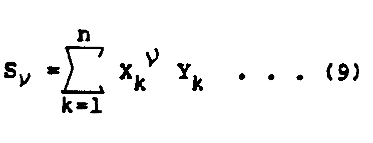 where,
v= 0 to d - 2
n : Number of erasure
Xₖ : Location of kth
Sᵥ : Syndrome
Yk: Magnitude of error in the erasure of kth
d : Minimum distance of code
   Here, n, Xₖ, S_{v"}, are known, Yₖ is unknown.

To solve the above equation, the following method has been conventionally adopted: if 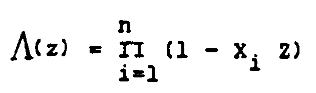 w(z) _{= S}(_{z}) _{A}(_{z}) _{mod.} Z^{d} - 1
Yᵢ can be obtained as in expression (8) as follows:

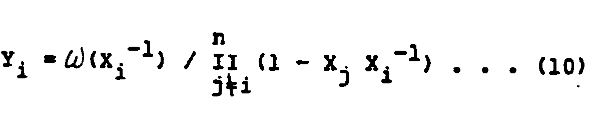

In this method, however, if the number of actual calculation steps is counted when d = 9 and n = 8, for instance.
(i) Expansion of A(z) Number of multiplications : 1 + 2 + ..... + 7 = 28 Number of additions : 1 + 2 + ..... + 7 = 28
(ii) Previous calculations for obtaining the denominator of 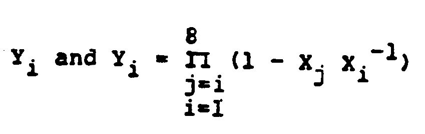 Number of reciprocals : 1 x 8 = 8 Number of multiplications : (7 + 6) x 8 = 104 Number of additions : 7 x 8 = 56
(iii) Calculations for obtaining m(z) = S(z) A(z), mod. Z⁸ Number of multiplications : 1 + 2 + ..... + 7 = 28 Number of additions : 1 + 2 + ..... + 7 = 28
(iv) Calculations for obtaining ω(Xᵢ-1) Number of reciprocals : 1 x 8 = 8 Number of multiplications : 7 x 8 = 56 Number of additions : 7 x 8 = 56
(v) Calculations for obtaining Yᵢ Number of division : 1 x 8 = 8
   When these calculations each need one step, the number of steps is 408 in total.

In the circuit shown in Fig. 6, the roots of expression (9) are calculated by: 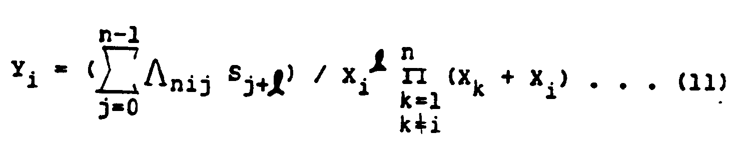 where Aₙᵢⱼ : Coefficient of Z^{j} of 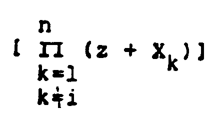
f : Any integer more than or equal to 0 which satisfies l ≦ d - n - 1

That is to say, in order to implement erasure correction, f = 0, i = n are substituted into the expression (11) as follows: 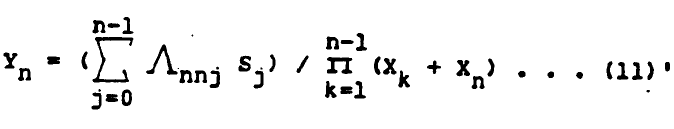 By this calculation, Yₙ is obtained and Yₙ Xₙ^{v} is added to each syndrome S as follows: 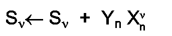 where v = 0 to n-2 Since the data at the location Xₙ are correct, the syndrome includes (n-1) erasures. Therefore, by reducing n by 1, Yₙ-₁ can be obtained: 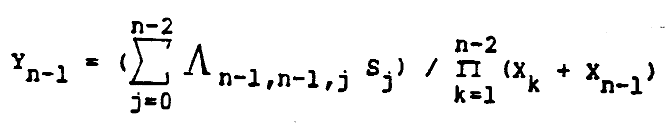 By this calculation, Yₙ-₁ is obtained and Yₙ-₁ Xₙ₋₁^{v} is added to each syndrome S as follows: 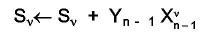 where v = 0 to n-3

by repeating the above, the last remaining erasure Y₁ can be obtained as

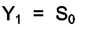

As explained above, an erasure correction can be implemented. In this case, the actual number of operation steps is counted in the same way as in the conventional method, provided that d = 9 and n = 8.
(i) Expansion of Aₙₙⱼ Number of multiplications : 1 + 2 + ..... + 6 = 21 Number of additions : 1 + 2 + ..... + 6 = 21
(ii) Previous calculations for obtaining the denominator of Yₙ, 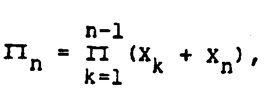 where it is sufficient to obtain only 11₃ to ll₈, since ll₂ = X₁ + Y₂ = A₃₃₁. Number of multiplications : 1 + 2 + ..... + 6 = 21 Number of additions : 1 + 2 + ..... + 6 = 21
(iii) Calculations for obtaining the numerator of Yₙ Number of multiplications : 7 + 6 + ..... + 1 = 28 Number of additions : 7 + 6 + ..... + 1 = 28
(iv) Calculations for obtaining Yₙ, since Y₁ = So Number of divisions : 7
(v) 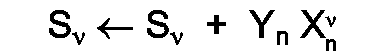 Number of multiplications : 6 + 5 + ..... + 1 = 21 Number of additions : 7 + 6 + ..... + 1 = 28
   The number of the above calculations steps is 202 in total.

Therefore, in the case of expression (11), it is possible to reduce the number of calculation steps to 50% of the conventional case in the expression (10).

Further, in the case where the above mentioned correction code is a product code, provided that 30 symbols are arranged in the vertical direction, 128 symbols are arranged in the lateral direction, the C₁ code is formed to the vertical direction, and the C₂ code is formed to the lateral direction, the erasure corresponds to the location of the C₁ pointers, and the location Xₖ (k=1 to n) is the same in all the C₂ code series. This means that it is possible to previously calculate Aₙₙⱼ and 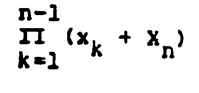 in expression (11)' without calculating these terms every C₂ decoding. That is to say, in this example, the above calculation is implemented only once while the C₂ decoding is performed 30 times.

Therefore, in the number of the above calculation steps, since the number of calculations of (i) and (ii) is only once every 30 times of C₂ decoding, provided that the number of steps of (i) and (ii) is 90/30 = 3, the total number of steps is 115. compared with that in the conventional method, where the number of steps in (i) and (ii) is 224/3 = 74.7 and the total number of steps is 191.5, it is possible to reduce the number of steps by about 40%.

Accordingly, the method as above described has advantages such that it is possible to markedly reduce the number of calculation steps, processing time, hardware load for processing and so on as compared with the conventional method.

Additionally, although the above calculations are performed by employing the operation logic 37, in the case where, for example, Sv ← Sᵥ + Xᵢ^{v} Yᵢ is obtained, an arrangement as shown in Fig. 7 is adopted. In Fig. 7, the reference numerals 38, 39, 40 denote registers, the reference numeral 41 denotes an adder, the reference numeral 42 denotes a multiplier, the reference numeral 43 denotes a selector, which are all built in the operation logic 37. In this circuit,
[1] So is set to the register 38, Yᵢ is set to the register 39, and Xᵢ is set to the register 40, respectively through the data bus 28 from the syndrome register 29 and the working RAM 36 and so on. So + Yᵢ is outputted from the adder 41 to the data bus 28.
[2] The content of the multiplier 42, Xᵢ Yᵢ, is fedback to the register 39 through the selector 43, and S₁ is set to the register 38 from the data bus 28. Therefore, S₁ + Xᵢ Yᵢ is outputted from the adder 41 to the data bus 28.
[3] Further, the content of the multiplier 42, Xᵢ2 Yᵢ is fedback to the register 39 through the selector 43, and S₂ is set to the register 38 from the data bus 28. Therefore, S₂ + Xᵢ² Yᵢ is outputted from the adder 41 to the data bus 28.
[4] By repeating the above steps, S₃ + Xᵢ3 Yᵢ, S₄ X,4 Yᵢ, .... are obtained sequentially and supplied to the syndrome register 29 through the data bus 28 so as to rewrite each value. The calculations are implemented as described above.

In the above explanation, although all of X₁ to Xₙ are assumed as erasures, in the case where X₁ to Xₙ-₁ are erasures and Xₙ is an error, it is possible to correct the symbols. In this case, the number of unknown quantity are (n+1) of Y₁ to Yₙ and Xₙ. Xₙ can be obtained by using the above Aₙₙⱼ as follows: 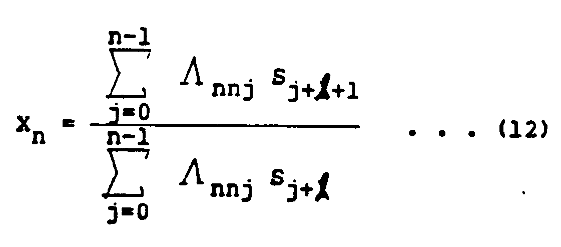 Therefore, the unknown quantity are Y₁ to Yₙ, and thereafter, this unknown quantity can be obtained in the same way as in the erasure correction.

For instance, in the case where d = 9 (6 erasures + 1 error) in product code,
[1] Check locations of the erasures X₁, X₂, ..... , X₆.
[2] Obtain and store Aₙₙⱼ, here 21 symbols in total of Λ₂₂₁ =X₁, A₃₃₁ =Λ₂₂₁ +X₂, A₃₃₂ =Λ₂₂₁ X₂, ..... , Λ₇₇₁, ..... , Λ₇₇₆.
[3] Obtain and store 5 symbols in total of 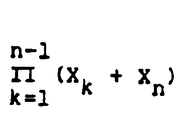 (n=2 to 6).

The above processings are made once for each of the 30 decoding cycles.
[4] Calculate syndromes So to S₇.
[5] Obtain X₇ by an expression as follows: 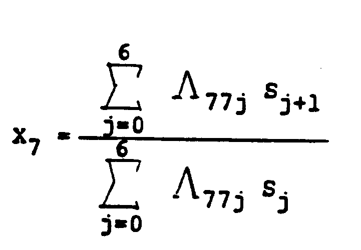
[6] Obtain Y₇ by the following expression and feedback the syndrome Y₇ X₇ :

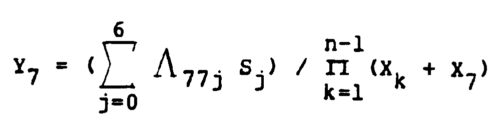

Thereafter, Y₆ to Y₁ (= So) are sequentially obtained.

Although a case where expression (11)' is used is shown in this example, the operation is the same if 1 ≠0.

As described above, it is possible to implement the correction of errors including erasures and one error. In this case, the number of calculation steps can be reduced as in the erasure correction described above.

The proof of the above expressions (11) and (12) will be described hereinafter:
[Lemma] If 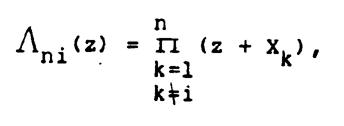 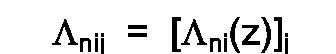 the following expression is cleary obtained:

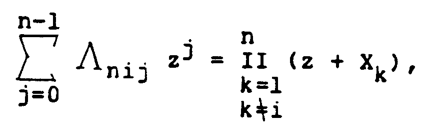

[Theorem 1] The n-order linear simultaneous equations:

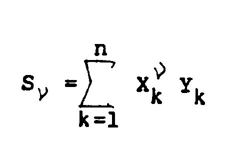

(v = 0 to n-1 : Yᵢ is unknown quantity) has the roots as:

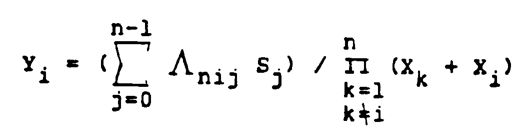

### (Proof)

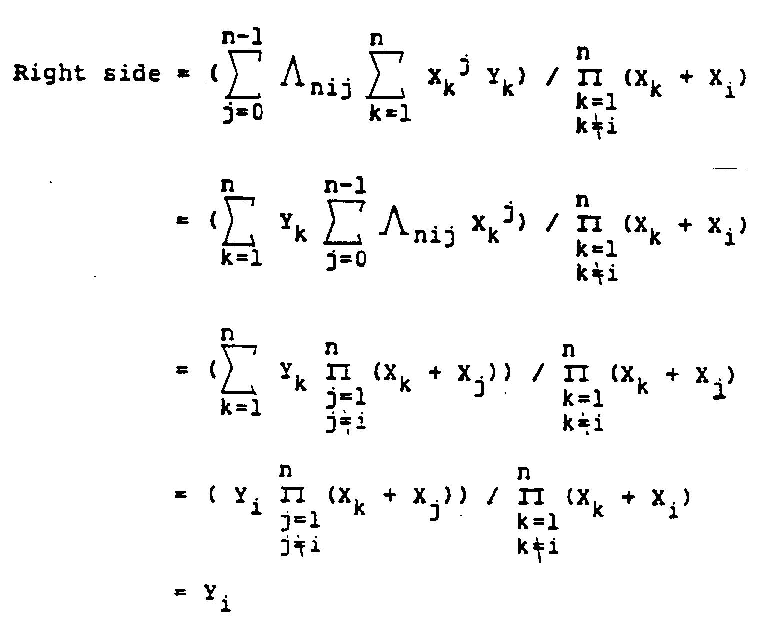

### (Corollary 1)

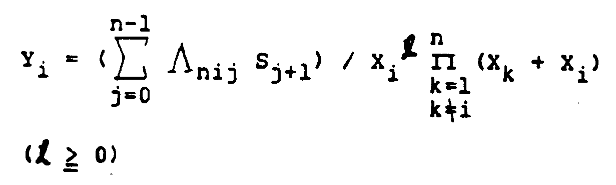

(Proof) It is clearly proved by substituting into the above ;

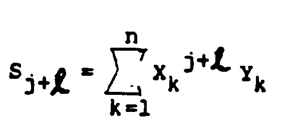

[Theorem 2] If Xᵢ to Xₙ₋₁ : Erasure and Xₙ is an error,

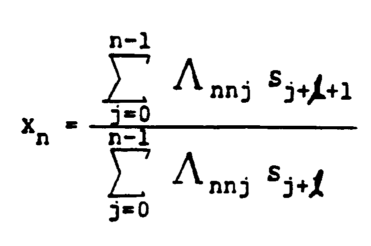

(Proof) From Corollary 1, 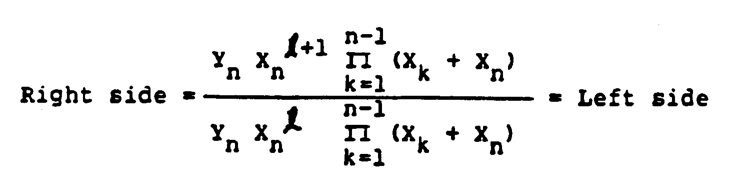 Therefore, it is understood from Theorem 1 that errors can be corrected in the erasure correction by use of any of S₁ to Sₙ, S₂ to Sₙ₊ᵢ, ..... , S_{d-1- n} to S_{d}-₂ among the series of So to Sₙ-₁. That is, n continuous syndromes are necessary for n erasure corrections, the remaining syndromes are usable for checking, so that n ≦ d-1.

Further, to obtain Xₙ from theorem 2, a total of n+1 syndromes of Sₗ to S_{n+f} are necessary, so that n ≦ d-2. In this case, the number of erasures is n-1 ≦ d-3. The remaining syndromes can be used for checking as in the above case.

In the conventional method, the pointer areas are required for the total number of data (n₁, n₂) corresponding to the error correction code. According to the present invention, however it is possible to reduce the number of pointers to (n₂ + 2n₁) and further to reduce the capacity of the memory required in decoding Further, according to the present invention, it is possible to reduce the number of steps for writing or reading the pointers. Further, according to the present invention, in the case where the erasure correction in the C₂ decoding is implemented by the use of pointers formed by the C₁ decoding, since the pattern of the pointers with respect to each series of C₂ code is common and a part of the operations to obtain error value becomes common, it is possible to implement the operation only once. Therefore it is possible to markedly reduce the number of processing steps in decoding and to realize a high-speed in decoding operation.

Furthermore, according to the present invention, without necessity to obtain the whole error values in accordance with a complicated error evaluation polynomial in obtaining a plurality of error values, it is possible to obtained one of the error values by a simple construction and to reduce the number of the processing steps.

Moreover, according to the present invention, it is possible to markedly reduce the number of calculation steps in erasure correction.

The present application describes matter described and claimed in the copending application EP-A-0167627 (85900195.0) from which this application is divided.

## Claims

1. A method for decoding and correcting Reed-Solomon code comprising the steps of: solving the expression 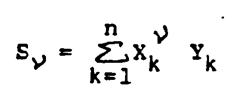 where,
v=0 to d - 2
n : Number of erasure
Xₖ : Location of kth element
Sᵥ : Syndrome
Yₖ: Magnitude of error in the erasure of kth element
d : Minimum distance of code
to obtain roots of the expression;
making erasure correction of errors encoded in the Reed-Solomon code in accordance with the roots, characterized in that; the roots are obtained by solving the expression 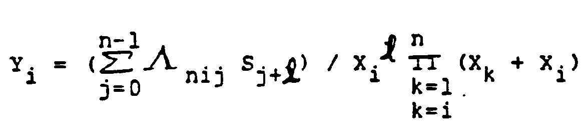 where Λₙᵢⱼ : Coefficient of Zi of 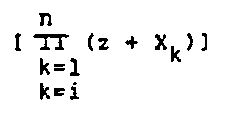 f : Any integer more than or equal to 0 which satisfies f < d - n - 1

2. An apparatus for decoding and correcting erasure in Reed-Solomon code in accordance with the roots of 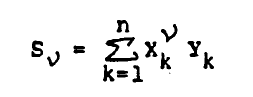 where,
v = 0 to d - 2
n : Number of erasure
Xₖ : Location of kth element
Sᵥ : Syndrome
Yₖ: Magnitude of error in the erasure of kth element
d : Minimum distance of the code
comprising syndrome register means (29) for storing syndrome Sᵥ; and characterized by: operating logic means (37) for obtaining the roots Yᵢ by solving the expression: 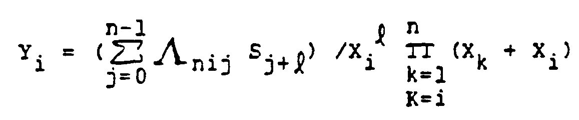 where Λₙᵢⱼ : Coefficient of Zi of 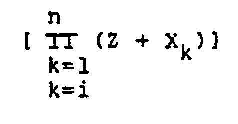
f : Any integer more than or equal to 0 which satisfies l ≦ d - n - 1 whereby said operating logic means (37) includes
register means (38) for storing syndrome Sᵥ;
register means (39) for storing Xᵢ^{v} Yᵢ;
register means (40) for storing Xᵢ;
adder means (41) for adding Sᵥ and Xᵢ^{v} Yᵢ and for supplying said register means (38) and syndrome register means (29) with Sᵥ + Xᵢ^{v} Yᵢ;
multiplyer means (42) for multiplying Xᵢ and Xᵢ^{v} Yᵢ and for supplying said register means (39) with Xᵢ^{v} Yᵢ.

## Patentansprüche

1. Verfahren zur Decodierung und Korrektur eines Reed-Solomon-Codes umfassend die Verfahrensschritte:
Lösen der Gleichung 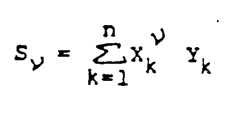 wobei,
v = 0 bis d - 2
n : Anzahl der Löschungen
xₖ : Ort des k-ten Elements
Sᵥ : Syndrom
Yₖ: Fehlergröße beim Löschen des k-ten Elements
d : Mindest-Distanz des Codes, um die Wurzeln des Ausdrucks zu erhalten;
Durchführung der Löschkorrektur der im Reed-Solomon-Code codierten Fehler in Übereinstimmung mit den Wurzeln,
dadurch gekennzeichnet,
daß die Wurzeln durch Lösen des Ausdrucks 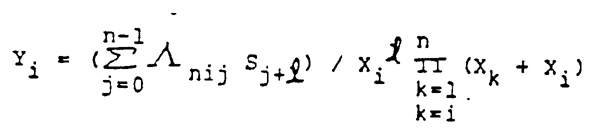 erhalten werden,
wobei Λₙᵢⱼ : Koeffizient von zi von 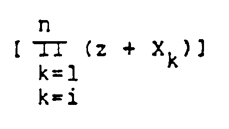
f : Jede ganze Zahl größer oder gleich 0, die die Bedingung erfüllt:
l < d - n - 1.

2. Vorrichtung zur Decodierung und Korrekturlöschung eines Reed-Solomon-Codes in Übereinstimmung mit den Wurzeln von 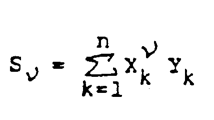 wobei,
v = 0 bis d - 2
n: Anzahl der Löschungen
xₖ : Ort des k-ten Elements
Sᵥ : Syndrom
Yₖ: Fehlergröße beim Löschen des k-ten Elements
d : Mindest-Distanz des Codes;
aufweisend eine Syndrom-Registereinrichtung (29) zur Speicherung des Syndroms Sᵥ; und gekennzeichnet durch
eine Logikschaltung (37), um die Wurzeln Y zu erhalten durch Lösen des Ausdrucks: 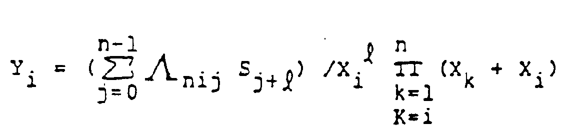
wobei Λₙᵢⱼ : Koeffizient von zi von 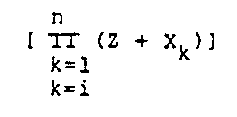
f : Jede ganze Zahl größer oder gleich 0, die die Bedingung erfüllt:
l ≦ d - n - 1,
wobei die Logikschaltung (37) aufweist
eine Registereinrichtung (38) zur Speicherung des Syndroms Sᵥ,
eine Registereinrichtung (39) zur Speicherung von Xᵢ^{v} Yᵢ,
eine Registereinrichtung (40) zur Speicherung von Xᵢ,
eine Addiereinrichtung (41) zurAddition von Sᵥ und Xᵢ^{v} Yᵢ und um der Registereinrichtung (38) und der Syndrom-Registereinrichtung (29) die Summe Sᵥ + Xᵢ^{v} Yᵢ zu liefern;
eine Multiplikatoreinrichtung (42) zur Multiplikation von Xᵢ und Xᵢ^{v} Yᵢ und um Xᵢ^{v} Yᵢ der Registereinrichtung (39) zu liefern.

## Revendications

1. Procédé pour décoder et corriger un code de Reed-Solomon comprenant les étapes qui consistent à :
résoudre l'expression 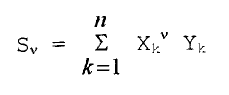 où,
v = 0 à d-2
n : Numéro d'effacement
Xₖ : Emplacement du k^{ième} élément
Sᵥ : Syndrome
Yₖ: Grandeur de l'erreur dans l'effacement du k^{ième} élément
d : Distance minimale du code
pour obtenir les racines de l'expression ;
exécuter une correction d'erreurs d'effacement codées dans le code de Reed-Solomon selon les racines, caractérisé en ce que :
les racines sont obtenues en résolvant l'expression 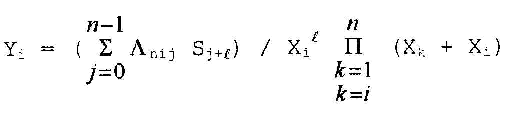 où Λₙᵢⱼ : Coefficient de Z^{j} de 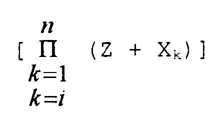
f : Tout entier supérieur ou égal à 0 qui satisfait f < d- n - 1.

2. Dispositif pour décoder et corriger un effacement dans un code de Reed-Solomon selon les racines de 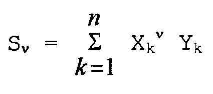 où
v = 0 à d-2
n : Numéro d'effacement
Xₖ : Emplacement du k^{ième} élément
Sᵥ : Syndrome
Yₖ: Grandeur de l'erreur dans l'effacement du k^{ième} élément
d : Distance minimale du code comprenant :
un moyen de registre de syndrome (29) pour mémoriser un syndrome S^{v} ; et
un moyen logique de traitement (37) pour obtenir les racines Yᵢ par la résolution de l'expression : 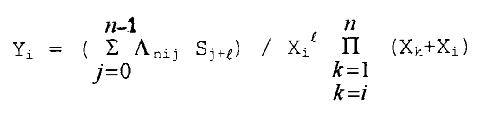 où Λₙᵢⱼ : Coefficient de Z^{j} de 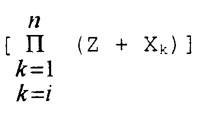 : Tout entier supérieur ou égal à 0 qui satisfait l ≦ d - n - 1
ledit moyen logique de traitement (37) incluant :
un moyen de registre (38) pour mémoriser un syndrome Sᵥ ;
un moyen de registre (39) pour mémoriser Xᵢ^{v} Yᵢ ;
un moyen de registre (40) pour mémoriser Xᵢ ;
un moyen additionneur (41) pour additionner Sᵥ et Xᵢ^{v} Yᵢ et pour fournir audit moyen de registre (38) et audit moyen de registre de syndrome (29) la valeur de (Sᵥ + Xᵢ^{v} Yᵢ) ;
un moyen multiplicateur (42) pour multiplier Xᵢ et Xᵢ^{v} Yᵢ, et fournir audit moyen de registre (29) la valeur de Xᵢ^{v} Yᵢ.
